# FASCICULE DE BREVET EUROPEEN

(11) **EP 0 378 631 B1**
(45) Date de publication et mention de la délivrance du brevet: **06.10.1993**
(21) Numéro de dépôt: 89907180.7
(22) Date de dépôt: 05.06.1989
(51) Int. Cl.: H05K 13/08, G01R 31/28, G01M 7/00

(54) **SYSTEME DE DETECTION DE PARTICULES LIBRES DANS UN BOITIER DE COMPOSANT ET PROCEDE DE DETECTION**
SYSTEM ZUM AUFFINDEN VON FREIEN PARTIKELN IN EINEM BAUTEILGEHÄUSE UND VERFAHREN ZUM AUFFINDEN
SYSTEM FOR DETECTING FREE PARTICLES IN A COMPONENT HOUSING AND DETECTION PROCESS

(30) Priorité: 03.06.1988 FR 8807403
(43) Date de publication de la demande: 25.07.1990
(73) Titulaire: THOMSON-CSF, 75008 Paris (FR); CENTRE NATIONAL D'ETUDES SPATIALES, F-75039 Paris Cedex 01 (FR)
(72) Inventeur: POTIER, Daniel, F-02200 Soissons (FR); GRUAU, Jean, F-92402 Courbevoie Cédex (FR); LECRIVAIN, Albert, F-92402 Courbevoie Cédex (FR)
(74) Mandataire: Guérin, Michel
(86) Numéro de dépôt international: FR8900281
(87) Numéro de publication internationale: WO8912379

(56) Documents cités:
- GB-A- 2 108 774
- US-A- 3 534 589

## Description

L'invention concerne un système de détection de particules libres dans un boîtier de composant et son procédé de détection.

Le principe de recherche de particules dans les boîtiers de composants électroniques individuels est connu dans la technique. Il est maintenant mis en oeuvre par détection piézo-acoustique des impacts que ces particules créent sur les parois des boîtiers lorsque le composant est soumis à une vibration d'amplitude et de fréquence appropriées. Des appareils, qui déroulent une séquence de chocs (pour libérer des particules éventuellement "coincées") et de périodes de détection standardisées sont commercialisés depuis plusieurs années. Des particules dont la masse est de 10⁻⁶ grammes sont détectables par ce procédé. Ces connaissances ne sont cependant pas étayées par des documents et doivent donc être considérées comme état de la technique interne.

Ce procédé est avant tout un moyen d'améliorer les processus de fabrication de composants ; mais il est aussi le dernier rempart contre une pollution éventuellement dangereuse pour le bon fonctionnement dudit composant, engendrée ou emprisonnée lors de la fermeture de son boîtier.

Ce test est souvent requis pour les composants à usage spatial. Cependant, il se fait avant montage des composants sur plaques de circuits imprimés.

Lorsque les composants sont montés sur cartes de circuits imprimés, il devient difficile de réaliser un tel test en raison des risques de détériorations de la carte lors de ces manipulations.

L'identification des composants pollués par des particules et montés sur une carte imprimée complètement équipée s'imagine dès l'instant ou l'un de ces composants a été incriminé dans un processus de défaillance.

Elle s'impose lorsque :
- cette pollution est reconnue d'origine métallique,
- la probabilité de présence d'une pollution identique dans le reste du lot de composants est suffisante,
- la fonction assumée dans le matériel requiert une fiabilité exceptionnelle,
- le temps et les moyens financiers pour réaliser une (ou plusieurs) nouvelle(s) carte(s) font défaut.

Le test de composants déjà montés sur cartes de circuits imprimés est rendu difficile par le fait que :
- les cartes équipées sont de formats différents,
- le maintien mécanique des carte est délicat,
- les composants incriminés sont en boîtiers métalliques de type T099 ( 8,2 mm de diamètre, 4 mm de haut) et certains sont d'un abord difficile,
- les cartes sont vernies recto-verso,
- aucune altération mécanique, physique ou chimique des cartes n'est envisageable,
- la détection des composants pollués doit se faire sans ambiguïté,
- la mise en oeuvre de l'ensemble dans un contexte industriel doit être facile.

L'invention a pour objet un système permettant un tel test et évitant tout risque d'altération soit physique, soit mécanique, soit chimique de la carte et de ses composants.

L'invention concerne donc un système de détection de particules libres dans un ou plusieurs boîtiers de composants, lesquels sont montés sur une carte de circuits imprimés, comportant :
- une platine vibrante ;
- des moyens de création d'une dépression, solidaires de la platine vibrante, pour porter sur une de ses faces la carte de circuits imprimés et maintenir cette carte en position en raison de la dépression créée ;
- au moins un détecteur piézo-acoustique pouvant être couplé du point de vue acoustique à un ou plusieurs composants.

L'invention concerne également un procédé de détection de particules libres dans un ou plusieurs composants montés sur une carte de circuits imprimés et comportant les étapes suivantes :
- maintien de la carte de circuits imprimés sur une platine vibrante par création d'une dépression entre la carte et la platine vibrante ;
- mesure d'éventuels impacts sonores sur les parois de chaque composent par couplage acoustique d'au moins un détecteur piézo-acoustique à un ou plusieurs composants.

Les documents suivants font partie d'état de la technique. Le document US-A-3 534 589 décrit un dispositif permettant de tester par vibrations des objets susceptibles de contenir des particules libres.
Le document GB-A-2 108 774 décrit un dispositif de fixation par dépression d'une carte de circuits imprimés, en vue d'être utilisé dans un équipement de test électrique.

Les différents objets et caractéristiques de l'invention apparaîtront plus clairement dans la description qui va suivre, faite à titre d'exemple en se reportant aux figures annexées qui représentent :
- la figure 1, un exemple de réalisation simplifié du système de détection de l'invention ;
- la figure 2, un exemple de réalisation détaillé du système de fixation pneumatique d'une carte à tester selon l'invention ;
- la figure 3, un exemple de réalisation d'une plaque en matériau mou ;
- la figure 4, une plaquette creuse d'aspiration d'une carte ;
- la figure 5, un exemple de réalisation détaillé d'un capteur piézo-acoustique adaptable sur composant ;
- les figures 6 et 7, des exemples de réalisation d'embout d'adaptation pour composants ;
- la figure 8, le système de l'invention monté et prêt à fonctionner ;
- la figure 9, une installation générale permettant de mettre en oeuvre l'invention.

L'idée de base et originale du système tient dans le maintien des cartes et du capteur piézo-acoustique par dépression.

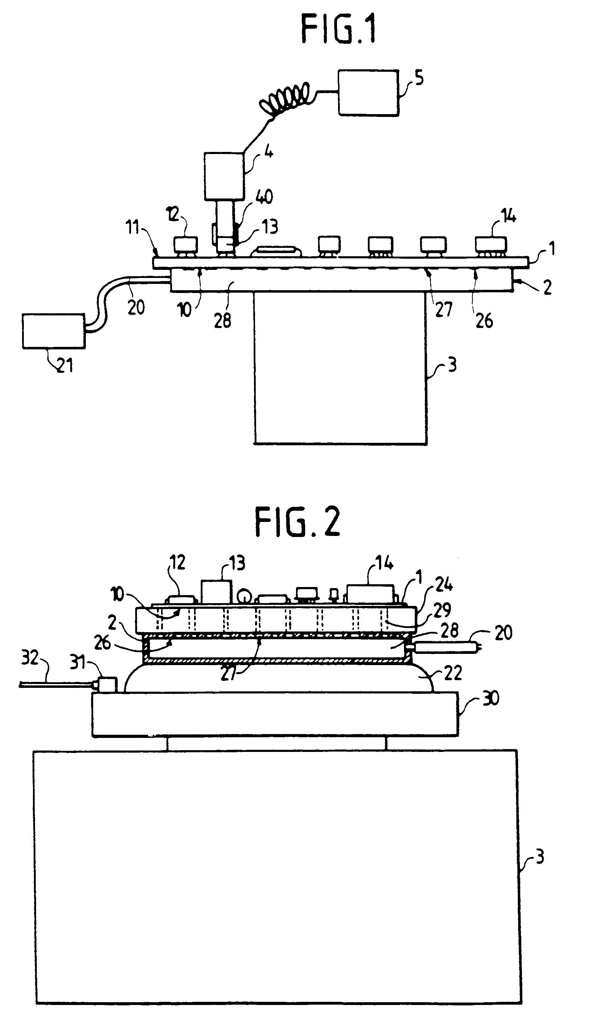

La figure 1 représente de façon simplifiée le système de l'invention.

Ce système comporte un dispositif vibrant 3 sur lequel est fixé un plateau creux 2, possédant un accès 20 par lequel une pompe 21 peut créer une dépression dans la cavité 28 du plateau. Une carte de circuits imprimés 1, portant sur sa face 11 des composants 12, 13, 14 à tester, est plaquée par sa face 10 contre la paroi 26 du plateau 2. Des orifices 27 du plateau sont prévus dans la paroi 26 du plateau 2. Ces orifices permettent lorsqu'une dépression est créée dans le plateau 2, de plaquer par aspiration la carte 1 sur le plateau 2. Une pompe 21 reliée à un accès 20 du plateau réalise cette dépression.

Par ailleurs, un capteur piézo-acoustique 4 peut être couplé de façon acoustique par un moyen de couplage 40 à un composant 13. Ce capteur 4 en contact avec la face supérieure du composant 13 détecte les impacts acoustiques créés dans le composant et fournit en échange un signal électrique à un dispositif de traitement et d'affichage 5.

Le fonctionnement d'un tel système est le suivant :
- le plateau 2 est fixé sur le dispositif vibrant 3 ;
- la carte de circuits imprimés est mise en place, par sa face 10 ne comportant pas de composants contre la paroi 26 du plateau ;
- la pompe 21 fait le vide dans la cavité 28 du plateau, ce qui a pour effet d'aspirer, par les ouvertures 27, la carte 1 et de plaquer celle-ci contre la paroi 26 ;
- un capteur piézo-acoustique 4 est alors appliqué successivement à chaque composant, tel que 13, à tester de façon à détecter la présence dans ces composants de particules libres qui sous l'effet des vibrations heurtent les parois intérieures des capots des composants. La présence de particules libres dans les composants peut ainsi être détectée.
- le dispositif vibrant 3 est mis en fonctionnement et fait vibrer le plateau 2 ainsi que la carte 1.

De plus, avant de réaliser la mesure à l'aide du capteur 4, il est possible de donner un ou plusieurs chocs au composant à tester pour décoller une particule qui pourrait être collée ou coincée dans le boîtier. Pour cela, ce ou ces chocs peuvent être communiquéeS par l'intermédiaire du capteur 4 par exemple.

En se reportant à la figure 2, on va maintenant décrire un exemple de réalisation détaillé du dispositif permettant de maintenir la carte de circuits imprimés 1 sur le dispositif vibrant 3.

Le dispositif vibrant 3 possède une platine d'excitation 30 soumise aux vibrations. Sur cette platine est monté un accéléromètre d'asservissement 31 permettant de mesurer les vibrations et de renvoyer, par une liaison 32 au dispositif de vibration 3, un signal d'asservissement de façon à régler la caractéristique des vibrations.

Le plateau 2 est maintenu sur la platine 30 à l'aide d'un mastic déformable ayant la propriété de transmettre les vibrations et qui sera décrit ultérieurement.

Comme sur la figure 1, le plateau 2 possède une cavité 28, un accès 20 permettant de créer une dépression dans la cavité 28, une paroi supérieure 26 comportant des ouvertures 27. La paroi supérieure 26 peut être tout simplement un couvercle perforé du plateau 2.

Sur la paroi 26 est placée une plaque 24 en matériau mou comportant des trous 29. Ces trous 29 communiquent avec des ouvertures 27 de la paroi 26.

Sur la plaque 24 est placée la carte de circuits imprimés 1 avec sa face 10 ne comportant pas de composants en contact avec la plaque 24. Les trous 29 de la plaque 24 sont situés de façon à ne pas correspondre à des trous de la carte 1.

Il est à noter que le système peut également fonctionner avec des composants sur la face 10 comportant des composants.

De cette façon, lorsqu'une dépression va être créée dans la cavité 28, la carte de circuits imprimés va être plaquée contre la plaque 24. La carte 1, la plaque 24, le plateau 2, le mastic 22 et la platine excitatrice 30 formeront donc un ensemble solidaire. Les vibrations de la platine seront transmises à la carte 1 sans qu'il n'y ait de bruits perturbateurs dus à des chocs mécaniques.

Les différents éléments du système ainsi décrit vont maintenant être détaillés.

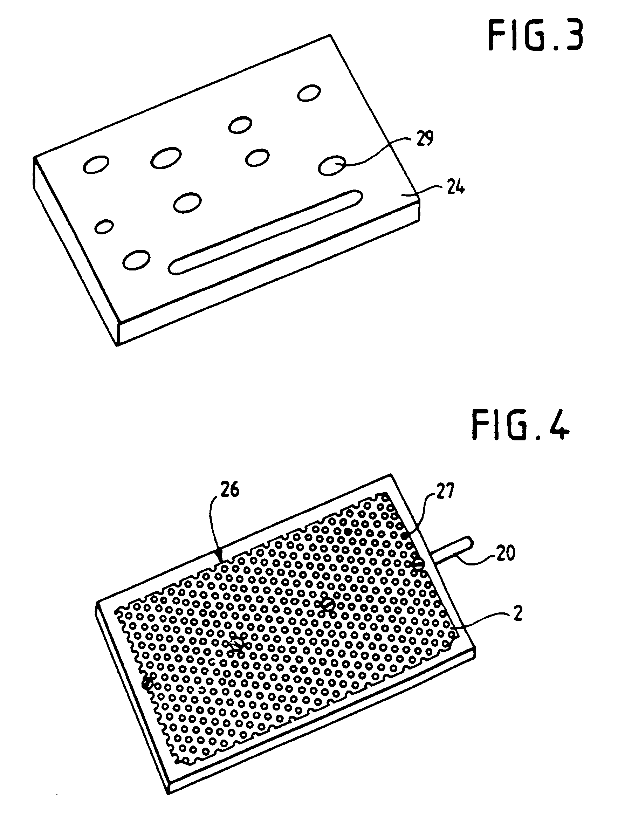

Conformément à ce qui a été décrit, la carte de circuits imprimés est posée sur une plaque 24 de mousse de polymère (figure 3) à alvéoles 29 fermées percée d'un nombre suffisant de trous 29, évitant les trous métallisés, les trous de fixation et de passage des frettes de la carte sous test. Cette plaque de mousse repose sur un plateau 2 relié à la pompe 21 et fixé à la tête du pot vibrant 30 par une couche de mastic d'étanchéité 22. Un dispositif rigide peut être substitué au mastic. Une carte différente requiert simplement une plaque de mousse percée différemment, parfois un plateau 2 différent.

Le maintien de la carte ne nécessite donc aucun bridage qui risquerait de blesser la carte et qui devrait être spécifique à la carte (à son format notamment). De plus, tout bridage par pinces et autre dispositif est générateur de bruit.

Le mastic d'étanchéité du type commercialement connu sous le nom de BOSTIK transmet fidèlement les chocs et accélérations. Sa plasticité facilite sa mise en oeuvre. Nous avons montré par ailleurs qu'il atténuait considérablement l'onde d'impact se propageant vers les composants voisins ; la discrimination d'un composant pollué est donc aisée. Ce dernier rôle est ici joué par la mousse élastique, plus facile à mettre en oeuvre. Le changement de cuvette métallique est rapide, l'adhérence du mastic étant suffisante.

La mousse élastique épouse les aspérités du verso de la carte (écrous, joints brassés, frettes...) sans altérer l'étanchéité de l'assemblage ; elle répartit régulièrement la force d'accélération sur la carte, limitant les résonances éventuelles ; elle rend le système indépendant du mode de fixation mécanique des cartes : comprimée, elle transmet fidèlement la vibration de l'excitateur. Elle ne doit pas générer de charges électrostatiques. La plaque 2 est mise à la masse.

Ainsi, avec un tel système, la dépression est calculée en fonction de la surface de la carte, de sa masse et de l'accélération maximale appliquée.

Le plateau 2 peut être réalisé comme représenté en figure 4 sous forme d'une cuvette fermée par un couvercle 26 muni de perforations 27.

Le capteur piézo-acoustique, qui détecte les impacts des particules, a une sensibilité suffisante mais sa taille trop importante, la proximité de composants voisins, la couche de vernis superficielle hétérogène, l'inadaptation des adhésifs envisagés, ne permettent pas qu'il soit plaqué directement sur le sommet du composant. Il a donc fallu faire appel à un adaptateur, aussi léger que possible, mais d'impédance acoustique convenable, qui transmette les impacts sans affaiblissement notable mais aussi les chocs que l'on applique au composant pour déloger les particules. Après divers essais, c'est le titane qui a été retenu pour confectionner cet adaptateur.

Le déplacement du capteur s'opère simplement en coupant la dépression, sans contrainte excessive pour le composant.

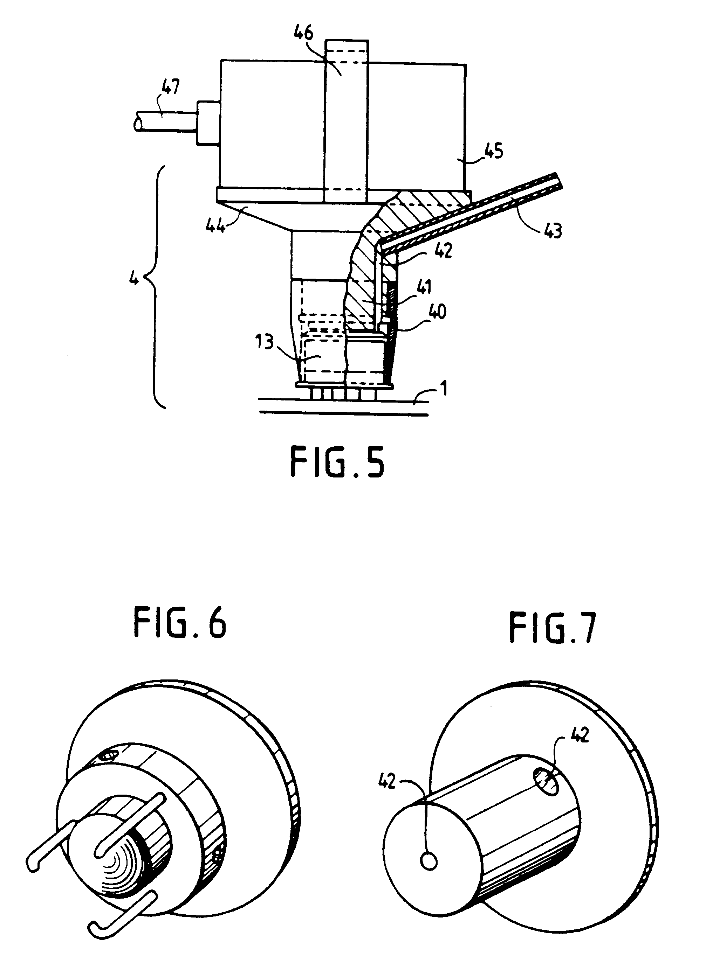

La figure 5 représente un exemple de réalisation de capteur piézo-acoustique et son montage sur un composent.

On retrouve donc sur la figure 5 la carte 1 avec un composant 13.

Le capteur comporte un microphone piézo-acoustique 45 solidaire d'un adaptateur métallique 44. Ce microphone 45 étant de dimension nettement plus grande que la dimension d'un composant à tester, un embout d'adaptation 41 est fixé par une extrémité à l'adaptateur 44 tandis que l'autre extrémité prévue pour être mise en contact avec le composant a des dimensions compatibles avec celle du composant 13.

Un embout d'adaptation 41 peut comporter des griffes, comme cela est représenté en figure 6 pour la fixation sur le composant à tester.

Il peut également comme cela est représenté en figure 7 posséder un conduit intérieur 42 que l'on voit déboucher d'une part sur la périphérie de l'embout et d'autre part à l'extrémité prévue pour être en contact avec le composant à tester. C'est ce type d'embout qui est utilisé avec le capteur de la figure 5.

L'embout 41 est posé sur la face supérieure du composant 13. Une collerette ou jupe d'étanchéité 40 est placée autour du composant et de l'embout. Cette jupe scelle de façon étanche l'interface située entre le composant et l'embout. En créant une dépression dans cette interface par le conduit 42 de l'embout et par le tuyau de pompage 43 branché au conduit, l'embout vient en contact avec le composant. Le tuyau de pompage 43 est de préférence un tuyau souple pour permettre de déplacer le capteur d'un composant à un autre et permettre le déplacement oscillatoire vertical dû aux vibrations du dispositif de vibration 3.

Il est à noter, bien que cela ne soit pas représenté sur la figure, que les liaisons mécaniques et acoustiques entre le composant et l'embout 41? entre l'embout 41 et l'adaptateur 44? et entre l'adaptateur 44 et le microphone 45 peuvent être assurée par un coupleur ultrasonique.

L'expérience a démontré que le caractère massif de l'embout adaptateur 41 est primordial pour la transmission de l'onde d'impact. Sa tête est usinée de façon à épouser le mieux possible le capot du composant. Les interstices sont comblés avec du couplant ultrasonique visqueux (tel que connu sous l'appellation AC. V9 ENDEVCO). La jupe de caoutchouc formant la cavité sous dépression est suffisamment souple pour absorber les irrégularités du vernis sans nuire à l'étanchéité. Cette dépression maintient l'adaptateur au contact en permanence (il a été montré que le vernis transmet l'onde d'impact).

Le capteur possède en outre une potence 46 permettant d'appliquer au composant des chocs de façon à décoller des particules se trouvant coincées ou collées dans le boîtier.

Le capteur est connecté électriquement par une liaison 47 à des circuits de mesure et leur transmet les signaux acoustiques détectés. Ces circuits de mesure comprennent une chaîne permettant l'amplification, le filtrage et des indicateurs sonores et d'affichage visuel.

Lors d'une mesure, la moindre fuite au niveau de la carte et de l'adaptateur est "bruyamment" détectée (c'est l'un des usages premiers des capteurs piézo-acoustiques) car créant un bruit continu. De même les bruits (contacts câbles...) synchrones de l'excitation sont aisément repérables.

Le système constitué par le dispositif de la figure 2 et le capteur de la figure 5 constitue un ensemble permettant donc bien de réaliser des tests de composants montés sur une carte de circuits imprimés.

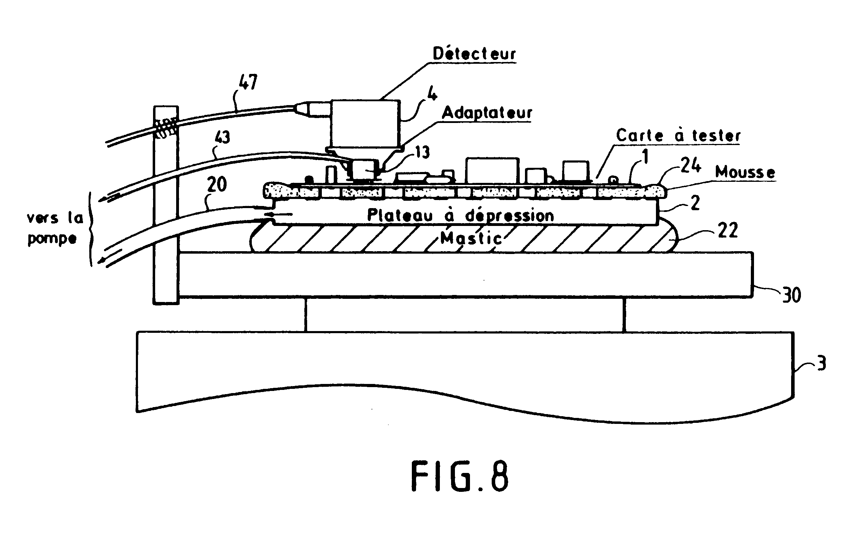

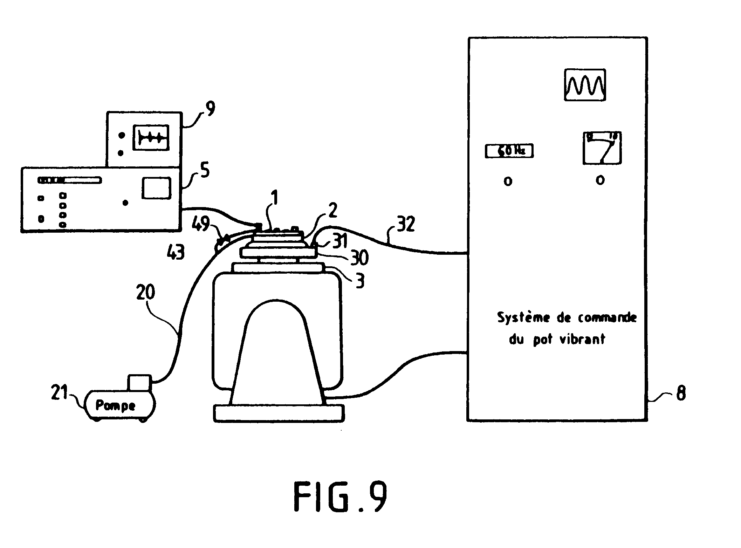

Pour réaliser un test de composants de carte avec un tel système, on procède de la manière suivante en utilisant les installations des figures 8 et 9.

Comme cela est représenté sur la figure 8, la carte est placée sur l'ensemble du système décrit précédemment.

La fixation de la carte est assurée par un dispositif pneumatique (figure 2). Ce dispositif est constitué d'un caisson métallique (plateau à dépression) dont la face supérieure ajourée est recouverte d'une plaque de mousse néoprène par exemple, perforée sur laquelle on vient poser la carte.

Lors de la mise en marche de la pompe 21 (figure 9), la dépression créée à l'intérieur du plateau 2 est transmise au travers des perforations de la mousse 24 et vient aspirer la carte à tester 1 qui se trouve ainsi solidaire de l'ensemble. Ce plateau à dépression est lui-même maintenu sur le plateau 30 du pot vibrant à l'aide d'une galette de mastic 22.

Ce dispositif permet une fixation aisée et sûre en évitant les résonances ainsi que toute contrainte susceptible d'endommager ou de fragiliser la carte.

Le plateau 2 peut être choisi en fonction de la carte à tester.

La plaque de mousse peut également être découpée et perforée en fonction de la carte. A titre d'exemple, l'épaisseur de la plaque de mousse pourra être de 5 à 6 mm et avoir des dimensions supérieures à celles de la carte de 5 mm. Les trous seront perforés à l'emporte-pièce de diamètre de 5 à 10 mm et seront répartis régulièrement sur la plaque.

Avant les tests, il sera procédé à un contrôle de l'accélération résultante au niveau de la carte par mesure du déplacement en stroboscopie. Le niveau d'excitation appliqué au pot vibrant sera réglé de façon à ne pas dépasser la valeur requise (10 g par exemple) pour le test de la carte.

Par ailleurs, ce contrôle permettra de s'assurer de la tenue de la fixation pneumatique de la carte et de l'absence de résonance du système.

Pendant toute la durée des tests une chaîne de mesure accélérométrique permettra la surveillance du niveau d'excitation du plateau du pot vibrant à l'aide de l'accéléromètre 31 de l'appareil de réglage 8.

Ensuite pour chaque composant la séquence de test sera la suivante :
- Humecter la face supérieure du composant à tester avec une goutte de produit couplant.
- Placer le capteur piézo-acoustique 4 muni de son embout adaptateur 41 sur le composant. Ouvrir l'aspiration, l'adaptateur descend et vient se plaquer sur la face supérieure du composant. L'aspiration pourra être réalisée par la même pompe 21 que précédemment et une vanne 49.
- S'assurer que le bruit de fond observé sur le moniteur est inférieur à une valeur limite. Dans le cas contraire, rechercher les fuites d'air possibles au niveau de la carte 1 ou de l'embout de l'adaptateur 41.
- Nettoyer la carte par soufflage d'azote sec.
- Choisir la fréquence d'excitation du pot vibrant 3. Compte tenu de la hauteur de la cavité des boîtiers des composants on choisira une fréquence fixe, comprise entre 60 et 70 Hz par exemple.
- Appliquer le signal d'excitation au pot vibrant. En monter progressivement le niveau jusqu'à la valeur requise 10g crête par exemple.
- S'assurer que le signal présent sur le moniteur 9 de la chaîne de détection n'a pas une forme et une récurrence caractéristique d'un mauvais contact ou d'une perturbation mécanique (câble, tuyaux de pompage).
- Si aucun impact caractéristique de la présence d'une particule n'est observé sur le moniteur 9, donner un choc sur le corps de l'adaptateur à l'aide d'une tige de cuivre, sur la potence 46 telle que représentée en figure 5. Observer et écouter immédiatement après ce choc, les impacts éventuels de particules.

En l'absence d'impact répéter cette séquence.
- En cas de détection confirmée ou en l'absence d'impact après cinq chocs par exemple, arrêter (progressivement) l'excitation du pot vibrant.
- Après avoir coupé l'aspiration de l'embout adaptateur 41 passer au composant suivant en reprenant la même séquence.

Lorsque tous les composants d'une carte ont été testés, arrêter la pompe 21 du dispositif de fixation pneumatique.

L'ensemble ainsi décrit a été expérimenté avec succès sur des prototypes ayant servi à des essais préliminaires mais surtout sur des composants dont la pollution intrinsèque est de même nature que celle des composants à localiser sur des cartes.

Il est bien évident que la description qui précède n'a été faite qu'à titre d'exemple non limitatif. Les exemples numériques n'ont été fournis que pour illustrer la description.

## Revendications

1. Système de détection de particules libres dans un ou plusieurs boîtiers de composants (12, 13, 14) lesquels sont montés sur une carte de circuits imprimés (1), comportant :
- une platine vibrante (3) ;
- des moyens (2) de création d'une dépression, solidaires de la platine vibrante (3), pour porter sur une de ses faces la carte de circuits imprimés (1) et maintenir cette carte en position en raison de la dépression créée ;
- au moins un détecteur piézo-acoustique (4) pouvant être couplé du point de vue acoustique à un ou plusieurs composants (12, 13, 14).

2. Système selon la revendication 1, caractérisé en ce que les moyens (2) de création d'une dépression comportent une pièce creuse (2) possédant une face plane (26) permettant d'appliquer la carte (1) cette face plane (26) possédant une ou plusieurs ouvertures (27) communiquant avec la cavité (28) de la pièce creuse, celui-ci possédant en outre un accès d'air (20) permettant de créer une dépression dans la cavité (28) de la pièce creuse.

3. Système selon la revendication 2, caractérisé en ce qu'il comporte entre la carte (1) et la face plane (26) de la pièce creuse (2) une plaque (24) en matériau mou possédant un ou plusieurs trous (29) correspondant chacun avec au moins une ouverture (27) du corps creux.

4. Système selon la revendication 2, caractérisé en ce que la face plane (26) possède une pluralité d'ouvertures (27) disposées régulièrement.

5. Système selon la revendication 3, caractérisé en ce que la plaque en matériau mou (24) possède des trous (29) situés en fonction de la carte de façon à ne pas être en correspondance avec des trous de la carte.

6. Système selon la revendication 2, caractérisé en ce qu'il comporte une pompe (21) connectée à l'accès d'air (20) de façon à créer la dépression dans la pièce creuse (2).

7. Système selon la revendication 2, caractérisé en ce qu'il comporte, entre la pièce creuse (2) et la platine vibrante (3), une couche d'un matériau déformable (22) permettant de transmettre les ondes de chocs.

8. Système selon la revendication 1, caractérisé en ce qu'il comporte un accéléromètre (31) connecté à la platine vibrante (30) ou aux moyens de dépression, permettant de mesurer les accélérations de vibration auxquelles est soumise la carte (1) et fournissant un signal de mesure d'accélération, ainsi que des moyens de commande de vibrations (8) recevant le signal de mesure d'accélération et commandant en conséquence la vibration de la platine vibrante.

9. Système selon la revendication 1, caractérisé en ce que le détecteur piézo-acoustique (4) comporte un embout (41) adaptable au moins à un composant (13) et possédant des moyens de solidarisation à ce ou ces composants.

10. Système selon la revendication 9, caractérisé en ce que les moyens de solidarisation comportant des griffes permettant d'accrocher l'embout (41) au composant à tester.

11. Système selon la revendication 9, caractérisé en ce que l'embout adaptable (41) comporte un orifice (42) atteignant l'interface constituée par l'extrémité de l'embout et la face supérieure du composant, des moyens de pompage étant en outre reliés à cet orifice pour faire le vide dans ledit interface et provoquer le placage de l'embout contre ledit composant.

12. Système selon la revendication 11, caractérisé en ce qu'il comporte une collerette d'étanchéité (40) permettant de réaliser l'étanchéité entre l'embout (41) et le composant (13).

13. Système selon la revendication 1, caractérisé en ce qu'il comporte un dispositif de traitement (5) recevant un signal de mesure du détecteur piézo-acoustique (4) et fournissant un signal d'affichage à un dispositif d'affichage (9).

14. Système selon la revendication 1, caractérisé en ce que le détecteur piézo-acoustique (4) possède des moyens (46) pour donner des chocs, lesquels sont transmis au composant à tester par l'intermédiaire du détecteur piézo-acoustique (4).

15. Procédé de détection de particules libres dans un ou plusieurs composants (12, 13, 14) montés sur une carte de circuits imprimés (1), comportant les étapes suivantes :
- maintien de la carte de circuits imprimés (1) sur une platine vibrante (3) par création d'une dépression entre la carte (1) et la platine vibrante (3);
- mesure d'éventuels impacts sonores sur les parois de chaque composant par couplage acoustique d'au moins un détecteur piézo-acoustique (4) à un ou plusieurs composants (12, 13, 14).

16. Procédé selon la revendication 15, caractérisé en ce qu'il comporte avant l'étape de mesure d'impacts, au moins une étape permettant de communiquer un ou plusieurs chocs à chaque composant de façon à décoller dans chaque composant d'éventuelles particules libres.

## Claims

1. System for detecting free particles in one or more component housings (12, 13, 14) which are assembled on a printed-circuit card (1), comprising:
- a vibrating stage (3);
- vacuum-generating means (2) fixed to the vibrating stage (3), for carrying the printed-circuit card (1) on one of its faces and holding this card in position as a result of the generated vacuum;
- at least one piezo-acoustic detector (4) which can be coupled acoustically to one or more components (12, 13, 14).

2. System according to Claim 1, characterised in that the vacuum-generating means (2) comprise a hollow part (2) having a plane face (26) making it possible to apply the card (1) to it, this plane face (26) possessing one or more orifices (27) communicating with the cavity (28) of the hollow part, the latter also having an air access (20) making it possible to generate a vacuum in the cavity (28) of the hollow part.

3. System according to Claim 2, characterised in that it possesses, between the card (1) and the plane face (26) of the hollow part (2), a pad (24) made of soft material, having one or more holes (29), each corresponding to at least one orifice (27) of the hollow body.

4. System according to Claim 2, characterised in that the plane face (26) has a plurality of orifices (27) arranged regularly.

5. System according to Claim 3, characterised in that the pad of soft material (24) has holes (29) arranged according to the particular card, so as not to correspond to holes in the card.

6. System according to Claim 2, characterised in that it possesses a pump (21) connected to the air access (20) so as to generate a vacuum in the hollow part (2).

7. System according to Claim 2, characterised in that it possesses, between the hollow part (2) and the vibrating stage (3), a layer of deformable material (22) making it possible to transmit the shock waves.

8. System according to Claim 1, characterised in that it possesses an accelerometer (31) connected to the vibrating stage (30) or to the vacuum means, making it possible to measure the vibrational accelerations to which the card (1) is subjected, and supplying an acceleration measurement signal, and vibration control means (8) receiving the acceleration measurement signal and controlling the vibration of the vibrating stage accordingly.

9. System according to Claim 1, characterised in that the piezo-acoustic detector (4) possesses an adaptor piece (41) adaptable to at least one component (13) and having means for fixing it to this component or to these components.

10. System according to Claim 9, characterised in that the fixing means comprising claws make it possible to attach the adaptor piece (41) to the component to be tested.

11. System according to Claim 9, characterised in that the adaptor piece (41) has an orifice (42) reaching the interface consisting of the end of the adaptor piece and of the upper face of the component, pumping means also being connected to this orifice in order to generate a vacuum in the said interface and cause the adaptor piece to be laid against the said component.

12. System according to Claim 11, characterised in that it possesses a sealing flange (40) making it possible to ensure sealing between the adaptor piece (41) and the component (13).

13. System according to Claim 1, characterised in that it possesses a processing device (5) receiving a measurement signal from the piezo-acoustic detector (4) and supplying a display signal to a display device (9).

14. System according to Claim 1, characterised in that the piezo-acoustic detector (4) possesses means (46) for imparting shocks which are transmitted by means of the piezo-acoustic detector (4) to the component to be tested.

15. Method for detecting free particles in one or more components (12, 13, 14) assembled on a printed-circuit card (1), involving the following steps:
- holding the printed-circuit card (1) on a vibrating stage (3) by the generation of a vacuum between the card (1) and the vibrating stage (3);
- measuring possible sound impacts on the walls of each component by the acoustic coupling of at least one piezo-acoustic detector (4) to one or more components (12, 13, 14).

16. Method according to Claim 15, characterised in that, before the impact-measuring step, it involves at least one step making it possible to impart one or more shocks to each component, so as to detach possible free particles in each component.

## Patentansprüche

1. System zur Detektion freier Teilchen in einem oder mehreren Gehäusen von Bauteilen (12, 13, 14), die auf einer Druckschaltungskarte (1) montiert sind, enthaltend:
- eine vibrierende Platine (3);
- Mittel (2) zur Erzeugung eines Unterdrucks, die mit der vibrierenden Platine (3) fest verbunden sind, damit diese auf einer Seiten die Druckschaltungskarte (1) trägt und diese Karte aufgrund des erzeugten Unterdrucks in ihrer Lage hält;
- wenigstens einen piezoakustischen Detektor (4), der mit einem oder mehreren Bauteilen (12, 13, 14) akustisch gekoppelt werden kann.

2. System nach Anspruch 1, dadurch gekennzeichnet, daß die Mittel (2) zur Erzeugung eines Unterdrucks ein hohles Teil (2) aufweisen, das eine ebene Fläche (26) besitzt, die das Anlegen der Karte (1) ermöglicht, wobei diese ebene Fläche (26) eine oder mehrere Öffnungen (27) besitzt, die mit dem Hohlraum (28) des hohlen Teils in Verbindung stehen, wobei das hohle Teil außerdem einen Luftanschluß (20) besitzt, der es ermöglicht, einen Unterdruck in dem Hohlraum (28) des hohlen Teils zu erzeugen.

3. System nach Anspruch 2, dadurch gekennzeichnet, daß es zwischen der Karte (1) und der ebenen Fläche (26) des hohlen Teils (2) eine Platte (24) aus einem weichen Material aufweist, die ein oder mehrere Löcher (29) besitzt, die jeweils mit wenigstens einer Öffnung (27) des hohlen Körpers übereinstimmen.

4. System nach Anspruch 2, dadurch gekennzeichnet, daß die ebene Fläche (26) mehrere regelmäßig angeordnete Öffnungen (27) besitzt.

5. System nach Anspruch 3, dadurch gekennzeichnet, daß die Platte (24) aus weichem Material Löcher (29) besitzt, die in Abhängigkeit von der Karte so angeordnet sind, daß sie nicht mit Löchern der Karte übereinstimmen.

6. System nach Anspruch 2, dadurch gekennzeichnet, daß es eine Pumpe (21) aufweist, die mit dem Luftanschluß (20) so verbunden ist, daß sie einen Unterdruck in dem hohlen Teil (2) erzeugt.

7. System nach Anspruch 2, dadurch gekennzeichnet, daß sie zwischen dem hohlen Teil (2) und der vibrierenden Platine (3) eine Schicht aus einem verformbaren Material (22) aufweist, die die Übertragung der Stoßwellen ermöglicht.

8. System nach Anspruch 1, dadurch gekennzeichnet, daß es einen Beschleunigungsmesser (31) aufweist, der mit der vibrierenden Platine (30) oder den Unterdruckmitteln verbunden ist, die Messung der Vibrationsbeschleunigungen ermöglicht, denen die Karte (1) ausgesetzt ist, und ein Beschleunigungsmeßsignal liefert, sowie Vibrationssteuermittel (8), die das Beschleunigungsmeßsignal empfangen und dementsprechend die Vibration der vibrierenden Platine steuern.

9. System nach Anspruch 1, dadurch gekennzeichnet, daß der piezoakustische Detektor (4) einen Ansatz (41) aufweist, der an wenigstens ein Bauteil (13) anpaßbar ist und Mittel zur festen Verbindung mit diesem Bauteil bzw. diesen Bauteilen besitzt.

10. System nach Anspruch 9, dadurch gekennzeichnet, daß die Befestigungsmittel Klauen aufweisen, die es ermöglichen, den Ansatz (41) an dem zu prüfenden Bauteil festzuhaken.

11. System nach Anspruch 9, dadurch gekennzeichnet, daß der anpaßbare Ansatz (41) eine Öffnung (42) aufweist, die bis zu der das Ende des Ansatzes bildenden Grenzfläche und der oberen Fläche des Bauteils reicht, wobei außerdem mit dieser Öffnung Pumpmittel verbunden sind, um ein Vakuum an dieser Grenzfläche zu erzeugen und das Anlegen des Ansatzes an das Bauteil zu verursachen.

12. System nach Anspruch 11, dadurch gekennzeichnet, daß es einen Dichtungsbund (40) aufweist, der es ermöglicht, die Abdichtung zwischen dem Ansatz (41) und dem Bauteil (13) zu erzielen.

13. System nach Anspruch 1, dadurch gekennzeichnet, daß es eine Verarbeitungsvorrichtung (5) enthält, die ein Meßsignal von dem piezoakustischen Detektor (4) empfängt und ein Anzeigesignal zu einer Anzeigevorrichtung (9) liefert.

14. System nach Anspruch 1, dadurch gekennzeichnet, daß der piezoakustische Detektor (4) Mittel (46) zur Abgabe von Stößen besitzt, die auf das zu prüfende Bauteil über den piezoakustischen Detektor (4) übertragen werden.

15. Verfahren zur Detektion von freien Teilchen in einem oder mehreren Bauteilen (12, 13, 14), die auf einer Druckschaltungskarte (1) montiert sind, enthaltend die folgenden Stufen:
- die Druckschaltungskarte (1) wird auf einer vibrierenden Platine (3) durch Erzeugung eines Unterdrucks zwischen der Karte (1) und der vibrierenden Platine (3) gehalten;
- eventuelle tönende Anschläge an die Wände jedes Bauteils werden durch akustische Kopplung wenigstens eines piezoakustischen Detektors (4) mit einem oder mehreren Bauteilen (12, 13, 14) gemessen.

16. Verfahren nach Anspruch 15, dadurch gekennzeichnet, daß es vor der Stufe der Messung von Anschlägen wenigstens eine Stufe enthält, die es ermöglicht, auf jedes Bauteil einen oder mehrere Stöße auszuüben, um in jedem Bauteil eventuelle freie Teilchen abzulösen.
